# EUROPÄISCHE PATENTSCHRIFT

(11) **EP 2 287 899 B1**
(45) Veröffentlichungstag und Bekanntmachung des Hinweises auf die Patenterteilung: **07.05.2014**
(21) Anmeldenummer: 10006522.6
(22) Anmeldetag: 23.06.2010
(51) Int. Cl.: H01L 23/482, H01L 21/60, H01L 23/373

(54) **Lötverbindung mit einer mehrlagigen lötbaren Schicht und entsprechendes Herstellungsverfahren**
Solder connection with a multilayered solderable layer and corresponding manufacturing method
Connexion par soudage avec une couche soudable à plusieurs couches et procédé de fabrication correspondant

(30) Priorität: 18.08.2009 DE 102009028621
(43) Veröffentlichungstag der Anmeldung: 23.02.2011
(73) Patentinhaber: SEMIKRON Elektronik GmbH & Co. KG, 90431 Nürnberg (DE)
(72) Erfinder: Berberich, Sven, Dr., 91080 Spardorf (DE)

(56) Entgegenhaltungen:
- WO-A1-01/43965
- WO-A1-93/11563
- DE-A1- 10 058 446
- DE-C1- 19 603 654
- DE-C1- 19 734 434
- JP-A- 2001 284 485
- JP-B2- 3 709 117
- US-A1- 2008 048 177
- "Teil 9. Film Structure" In: OHRING M: "Materials Science of Thin Films. Deposition and Structure", 2002, ACADEMIC PRESS, SAN DIEGO - SAN FRANCISCO - NEW YORK - BOSTON - LONDON - SYDNEY - TOKYO
- "Teil 5. Plasma and Ion Beam Processing of Thin Films" In: OHRING M: "Materials Science of Thin Films. Deposition and Structure", 2002, ACADEMIC PRESS, SAN DIEGO - SAN FRANCISCO - NEW YORK - BOSTON - LONDON - SYDNEY - TOKYO
- PATTEN J W: "Columnar grain structure in thick sputtered nickel", THIN SOLID FILMS, ELSEVIER-SEQUOIA S.A., LAUSANNE, CH, vol. 75, no. 3, 16 January 1981 (1981-01-16), pages 205-211, XP025729893, ISSN: 0040-6090, DOI: 10.1016/0040-6090(81)90397-7

## Beschreibung

Die Erfindung betrifft einen Chip nach dem Oberbegriff des Patentanspruchs 1 und ein entsprechendes Herstellungsverfahren nach dem Oberbegriff des Patentanspruchs 11.

Solche Chips werden insbesondere zur Herstellung von Leistungshalbleitermodulen verwendet. Sie werden zur Ableitung von Wärme üblicherweise auf eine Unterlage, z. B. ein DCB-Substrat oder eine metallische Platte, gelötet. Es wird verwiesen auf Lugscheider E. et al. "Spannungsreduktion in Chip-DCB-Verbunden mittels Ausnutzung der intrinsischen Spannungseigenschaften von PVD-Metallisierungsschichten", Verbundwerkstoffe und Werkstoffverbunde, M. Schimmerer (Hrsg.), 2005. Ferner können Lötverbindungen zur Herstellung elektrischer Anschlüsse notwendig sein.

Zur Herstellung der Lötverbindung ist auf zumindest einer Seite des Chipkörpers ein aus mehreren metallischen Schichten gebildeter Schichtverband vorgesehen. Der Schichtverband wird im Allgemeinen durch eine Edelmetallschicht abgeschlossen, welche eine unerwünschte Oxidation der darunter befindlichen metallischen Schichten verhindert. Unterhalb der Edelmetallschicht befindet sich üblicherweise eine Lötschicht, welche bei der Herstellung der Lötverbindung zumindest teilweise zusammen mit dem Lot aufschmilzt und nach der Erstarrung den Chipkörper über weitere mit der Lötschicht verbundene metallische Schichten mit der Unterlage fest verbindet.

Insbesondere bei der Herstellung von Chip-CDB-Verbunden kann es erforderlich sein, mehrere Lötvorgänge durchzuführen. Dabei kann es sein, dass insbesondere der aus den metallischen Schichten hergestellte Schichtverband mehrfach auf eine Temperatur von 200 bis 250°C erwärmt wird. Bei einem Wiedererwärmen einer bereits hergestellten Lötverbindung kann es dazu kommen, dass eine aus der Lötschicht und dem Lot erneut gebildete Schmelze in Richtung des Chipkörpers vordringt und unerwünscherweise weitere metallische Schichten des Schichtverbands durchdringt. Infolgedessen können sich Lunker innerhalb des Schichtverbands bilden. Solche Lunker bzw. Poren wirken einer guten mechanischen Festigkeit und/oder elektrischen Leitfähigkeit der Lötverbindung entgegen.

Aus den WO 93/11563 A1, DE 100 58 446 A1, US 2008/0048177 A1 und DE 197 34 434 C1 sind eine Halbleitervorrichtung und ein entsprechendes Herstellungsverfahren bekannt, wobei auf einem Chip ein Schichtverband zur Herstellung einer Lötverbindung vorgesehen ist, der aus mehreren übereinander folgenden, mittels eines physikalischen Beschichtungsverfahrens wie Sputtern hergestellten Metallschichten gebildet ist, wobei zwischen einer an einer Oberfläche des Schichtverbands befindlichen Edelmetallschicht und dem Chipkörper eine Lötbare Schicht aus Ni oder einer Ni/V-Legierung vorgesehen ist.

Aus JP 3 709 117 B2 ist eine elektronische Vorrichtung bekannt, in der eine durch Sputtern oder Aufdampfen abgeschiedene Nickelschicht als Diffusionssperrschicht vorgesehen ist, wobei die Nickelschicht zumindest eine durch eine Unterbrechung des Beschichtungsverfahrens gebildete Grenzfläche aufweist.

Teil 9 "Film Structure" des Buchs "Materials Science of Thin Films. Deposition and Structure "von M. Ohring (Academic Press, 2. Auflage, San Diego-San Francisco-New York-Boston--London-Sydney-Tokyo 2002) offenbart das Fachwissen betreffend die Mikrostruktur physikalisch aufgertagener Schichten, insbesondere Kristallgrößenverhältnisse als Funktion der Temperatur.

Aufgabe der Erfindung ist es, die Nachteile nach dem Stand der Technik zu beseitigen. Es soll insbesondere ein möglichst einfach und kostengünstig hergestellbarer Chip angegeben werden, der mit einer hohen Prozesssicherheit verlötet werden kann. Insbesondere sollen bei einer Mehrfachlötung eine gute mechanische Festigkeit und eine gute elektrische Leitfähigkeit der Lötverbindung gewährleistet sein.

Die Aufgabe wird durch die Merkmale der Ansprüche 1 und 11 gelöst. Zweckmäßige Ausgestaltungen der Erfindung ergeben sich aus den Merkmalen der Ansprüche 2 bis 10 und 12 bis 17.

Nach Maßgabe der Erfindung ist vorgesehen, dass die Lötschicht aus Ni oder einer Ni/V-Legierung gebildet ist und zumindest eine durch eine Unterbrechung des Beschichtungsverfahrens gebildete Grenzfläche aufweist. - Es hat sich überraschenderweise gezeigt, dass mit einer solchen, aus mehreren, jeweils durch eine Grenzfläche getrennten, Schichten gebildeten Lötschicht ein unerwünschter Durchbruch einer aus der Lötschicht und einem Lot gebildeten Schmelze durch weitere auf dem Substratkörper aufgebrachte Metallschichten verhindert werden kann. Der vorgeschlagene Chip lässt sich einfach und kostengünstig herstellen. Es ist dazu lediglich erforderlich, bei der Herstellung der Lötschicht das Beschichtungsverfahren zu unterbrechen, so dass sich zumindest eine Grenzfläche innerhalb der Lötschicht ausbildet. Im Bereich der Grenzfläche bildet sich innerhalb der Lötschicht eine Barriere aus, welche ein Vordringen einer aus dem Lot und der teilweise aufgeschmolzenen Lötschicht gebildeten Schmelze in Richtung des Chipkörpers hemmt. Es kommt infolgedessen nicht oder nur in einem sehr geringen Ausmaß zu einem Kontakt der Schmelze mit weiteren auf dem Chipkörper vorgesehenen Metallschichten. Eine dadurch bedingte unerwünschte Bildung von Lunkern und/oder Poren innerhalb des Schichtverbands kann damit sicher und zuverlässig vermieden werden. Der vorgeschlagene Chip zeichnet sich durch eine hohe Prozesssicherheit, insbesondere bei solchen Herstellungsprozessen aus, bei denen der Chip mehrmals Temperaturen im Bereich von 200 bis 250°C ausgesetzt wird.

Nach einer vorteilhaften Ausgestaltung der Erfindung ist eine im Kontakt mit dem Chipkörper befindliche Basisschicht des Schichtverbands im Wesentlichen aus Aluminium gebildet. Die Basisschicht dient der Anbindung des Schichtverbands an den Chipkörper.

Nach einer weiteren vorteilhaften Ausgestaltung ist eine zwischen der Lötschicht und der Basisschicht vorgesehene erste Zwischenschicht im Wesentlichen aus Ti oder Cr oder einer Legierung aus Ti und W gebildet. Die erste Zwischenschicht dient einer Haftvermittlung einer darauf aufgebrachten Lötschicht. Sie dient ferner als Barriere für eine aus einem Lot und der Lötschicht gebildete Schmelze.

Nach einer weiteren Ausgestaltung der Erfindung kann zwischen der Edelmetallschicht und der Lötschicht eine zweite Zwischenschicht vorgesehen sein, die im Wesentlichen aus Ti gebildet ist. Die weitere Zwischenschicht trägt zu einer weiteren Verbesserung der Prozesssicherheit bei.

Das zur Herstellung des Chipkörpers verwendete halbleitende Material kann im Wesentlichen aus einem der folgenden Materialien gebildet sein: Si, SiC, SiGe, GaAs.

Es ist vorgesehen, dass eine mittlere Kristallgröße der die Lötschicht bildenden Kristalle zumindest in einer senkrecht von der Grenzfläche weg weisenden Richtung zunächst zunimmt. Die Zunahme der mittleren Kristallgröße kann dabei sprunghaft oder auch im Wesentlichen stetig sein. Es ist auch vorgesehen, dass eine mittlere Kristallgröße der die Lötschicht bildenden Kristalle in einer Richtung von einer an einer Grenze zu einer weiteren Metallschicht befindlichen Kontaktfläche zur Grenzfläche hin zunächst zunimmt. D. h. zwischen der Grenzfläche und der Kontaktfläche weist die mittlere Kristallgröße vorteilhafterweise ein Maximum auf. Sofern innerhalb der Lötschicht mehrere Grenzflächen ausgebildet sind, kann die mittlere Kristallgröße auch zwischen zwei aufeinanderfolgenden Grenzflächen ein Maximum aufweisen. - Im Sinne der vorliegenden Erfindung wird unter dem Begriff "Maximum" oder "Minimum" jeweils ein relatives Maximum oder Minimum verstanden. D. h. es können innerhalb der Lötschicht senkrecht zur Grenzfläche beispielsweise mehrere Maxima einer mittleren Korngröße oder dgl. auftreten.

Bei der Grenzfläche handelt es sich um einen, beispielsweise im Rasterelektronenmikroskop beobachtbaren, Unstetigkeitshorizont im Gefüge. Das Gefüge weist im Bereich der Grenzfläche zumindest auf deren einer Seite eine vergleichsweise geringe mittlere Kristallgröße auf. Ferner weist eine Häufigkeit von in der Lötschicht enthaltenen Poren im Bereich der Grenzfläche ein Maximum auf. Insbesondere die Poren tragen dazu bei, dass eine Wärmeleitfähigkeit innerhalb der Lötschicht an der Grenzfläche bzw. den Grenzflächen jeweils ein Minimum aufweist.

Vorteilhafterweise beträgt eine Dicke der Lötschicht 0,7 bis 1,2 µm, vorzugsweise 0,8 bis 1,0 µm. Damit ist die Lötschicht etwa ebenso dick ausgebildet wie eine nach dem Stand der Technik bisher verwendete Lötschicht, welche in einem ununterbrochenen Beschichtungsvorgang hergestellt wird. Trotz der etwa selben Schichtdicke wie bei der Lötschicht nach dem Stand der Technik weist die erfindungsgemäße Lötschicht einen erheblich verbesserten Widerstand gegenüber einem Durchbruch einer aus der Lötschicht und dem Lot gebildeten Schmelze auf.

Bei dem physikalischen Beschichtungsverfahren zur Herstellung der Lötschicht und der weiteren Metallschichten handelt es sich um ein Sputter-Verfahren. Bei der Herstellung der erfindungsgemäßen Lötschicht wird das Sputter-Verfahren zur Herstellung der zumindest einen Grenzschicht, vorzugsweise von mehreren Grenzschichten, jeweils für 1 bis 60 Sekunden unterbrochen. Während der Unterbrechung des Sputter-Verfahrens kommt es zu einer Abkühlung einer zuvor abgeschiedenen Schicht. Die Abkühlung liegt im Bereich von 30 bis 100°C, vorzugsweise im Bereich 40 bis 80°C. Infolge der Abkühlung kommt es im Bereich der späteren Grenzfläche zu einem verminderten Kristallwachstum.

Nach weiterer Maßgabe der Erfindung wird ein Chip-Substrat-Verbund vorgeschlagen, bei dem ein erfindungsgemäßer Chip mittels eines mit der Lötschicht verbundenen Lots mit einem Substrat verbunden ist. Das Lot greift dabei in die Lötschicht ein. Bei der Herstellung der Lötverbindung schmilzt die Lötschicht teilweise auf. Es bildet sich zwischen dem Lot und der Lötschicht eine intermetallische Verbindung. Als Lot wird dabei beispielsweise eine Legierung aus Sn und Ag verwendet. Die Legierung kann Bestandteil einer Lötpaste sein. - Bei dem Substrat kann es sich um eine Metallplatte, insbesondere auch um einen Kühlkörper, handeln.

Bei dem Substrat kann es sich auch um ein DCB-Substrat handeln. Bei einem "DCB-Substrat" handelt es sich um ein nach dem Stand der Technik bekanntes "Direct Copper Bonding"-Substrat, auf dessen Oberfläche eine Kupferschicht vorgesehen ist. - Beim Chip-Substrat-Verbund ist das Lot mit einer auf dem DCB-Substrat vorgesehenen Kupferschicht in Kontakt. Solche Substrate werden nach dem Stand der Technik insbesondere zur Herstellung von Leistungshalbleitermodulen verwendet. Dabei werden die Chips mit ihrer daran vorgesehenen Metallisierung bzw. mit dem Schichtverband mittels Löten mit der auf dem DCB-Substrat vorgesehenen Kupferschicht verbunden.

Nachfolgend wird ein Ausführungsbeispiel der Erfindung anhand der Zeichnungen näher erläutert. Es zeigen:
- Fig. 1: eine schematische Schichtansicht durch eine Anordnung zur Herstellung eines Chip-DCB-Verbunds und
- Fig. 2: eine Detailansicht gemäß Fig. 1.

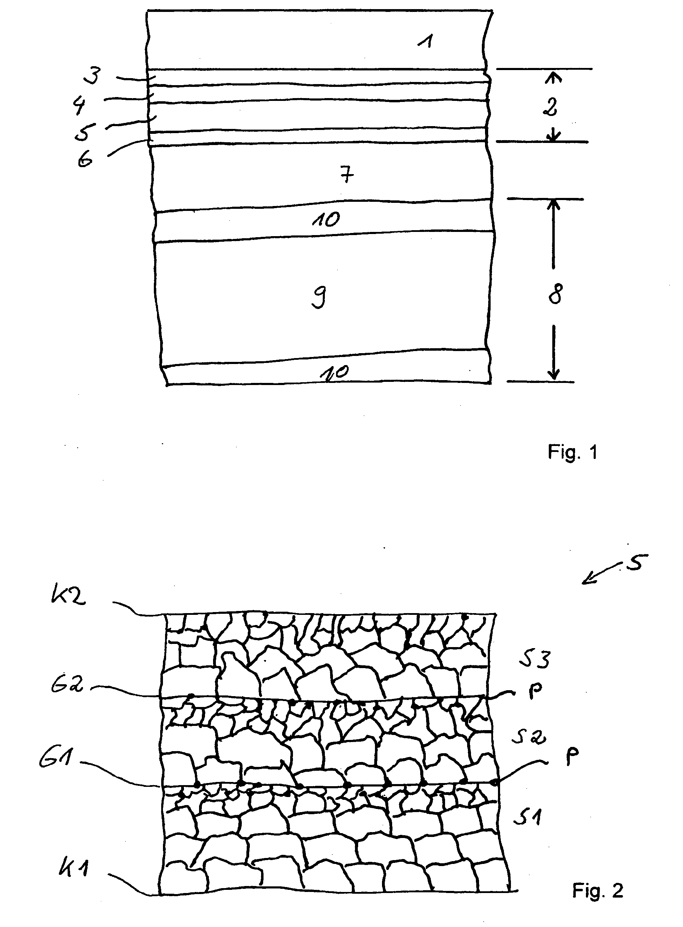

Fig. 1 zeigt eine Schichtansicht durch ein DCB-Substrat mit einem darauf angeordneten Chip, wobei zwischen dem Chip und dem DCB-Substrat eine Lötpaste vorgesehen ist. Durch Temperaturzufuhr kann aus einer solchen Anordnung ein fester Verbund des Chips mit dem DCB-Substrat hergestellt werden.

In Fig. 1 ist ein allgemein mit dem Bezugszeichen 1 bezeichneter Chipkörper beispielsweise aus Si hergestellt. An dessen einer Seite ist eine Metallisierung vorgesehen, welche aus einem allgemein mit dem Bezugszeichen 2 bezeichneten Schichtverband gebildet ist. Der Schichtverband 2 besteht aus mehreren metallischen Schichten, welche mittels eines Sputter-Verfahrens hergestellt sind. Eine Basisschicht 3 ist im Wesentlichen aus A1 gebildet. Eine darauf abgelagerte erste Zwischenschicht 4 kann im Wesentlichen aus einer TiW-Legierung bestehen. Auf der ersten Zwischenschicht 4 ist eine Lötschicht 5 abgelagert, welche aus mehreren (hier nicht gezeigten) Schichten besteht. Jede der Schichten ist aus Ni oder einer NiV-Legierung hergestellt. Mit dem Bezugszeichen 6 ist eine Edelmetallschicht bezeichnet, welche beispielsweise aus Ag, Au, Pt oder Pd hergestellt sein kann.

Zwischen der Lötschicht 5 und der Edelmetallschicht 6 kann eine (hier nicht gezeigte) zweite Zwischenschicht eingelagert sein. Die zweite Zwischenschicht kann beispielsweise aus Ti hergestellt sein.

Mit dem Bezugszeichen 7 ist eine Lötpaste bezeichnet, welche im Wesentlichen ein Lot enthält, welches aus einer Sn und Ag gebildeten Legierung hergestellt ist.

Mit dem Bezugszeichen 8 ist allgemein ein DCB-Substrat bezeichnet. Auf einem beispielsweise aus Al₂O₃ hergestellten Substratkörper 9 sind an dessen Unter- und Oberseite jeweils Kupferschichten 10 vorgesehen.

Fig. 2 zeigt eine Detailansicht der Lötschicht 5. Eine untere Kontaktfläche ist mit dem Bezugszeichen K1 und eine obere Kontaktfläche mit dem Bezugszeichen K2 bezeichnet. Eine erste Schicht S1 wird durch die erste Kontaktfläche K1 und eine erste Grenzfläche G1 begrenzt, eine zweite Schicht S2 durch die erste Grenzfläche G1 sowie eine zweite Grenzfläche G2 und eine dritte Schicht S3 durch die zweite Grenzfläche G2 sowie die zweite Kontaktfläche K2.

Wie aus Fig. 2 ersichtlich ist, ist im Bereich der Grenzflächen G1, G2 eine mittlere Kristallgröße kleiner als in einem etwa mittigen Bereich zwischen den Grenzflächen G1 und G2 oder zwischen den Grenzflächen G1 oder G2 und der benachbarten Kontaktfläche K1 oder K2. Ferner weist eine Häufigkeit von Poren P, insbesondere im Bereich der Grenzflächen G1, G2, ein Maximum auf. Insbesondere die im Bereich der Grenzflächen G1, G2 gebildeten Kristalle können sich senkrecht zur Grenzfläche G1, G2 säulenartig oder faserförmig erstrecken. Die Kristalle, welche entfernt von den Grenzflächen G1, G2 sich befinden, können dagegen eine Rekristallisationsstruktur aufweisen. So können aber auch säulenartig ausgebildet sein. Die Schichten S1, S2, S3 sind hier zweckmäßigerweise aus demselben Metall, Ni oder einer NiV-Legierung, hergestellt.

Die in Fig. 2 gezeigte Struktur wird mittels eines Sputter-Verfahrens durchgeführt. Zur Herstellung der Grenzflächen G1, G2 wird das Sputter-Verfahren für eine Dauer von beispielsweise 20 bis 50 Sekunden unterbrochen. Dabei kühlt die bis dahin abgeschiedene Schicht S1, S2 oder S3 beispielsweise um eine Temperatur im Bereich von 40 bis 70°C ab.

Anschließend wird das Sputter-Verfahren unter den gleichen Bedingungen fortgesetzt wie bei der Abscheidung der vorhergehenden Schichten S1, S2.

Eine Dicke der die Lötschicht 5 bildenden Schichten S1, S2, S3 liegt zweckmäßigerweise im Bereich von 0,2 bis 0,4 µm. Nach einer besonders vorteilhaften Ausgestaltung wird die Lötschicht 5 aus drei Schichten S1, S2, S3 gebildet, welche jeweils eine Dicke von 0,25 bis 0,35 µm aufweisen.

### Bezugszeichenliste

- 1: Chipkörper
- 2: Schichtverband
- 3: Basisschicht
- 4: erste Zwischenschicht
- 5: Lötschicht
- 6: Edelmetallschicht
- 7: Lot
- 8: DCB-Substrat
- 9: Substratkörper
- 10: Kupferschicht

- G1: erste Grenzfläche
- G2: zweite Grenzfläche
- K1: erste Kontaktschicht
- K2: zweite Kontaktschicht
- P: Pore
- S1: erste Schicht
- S2: zweite Schicht
- S3: dritte Schicht

## Patentansprüche

1. Chip, bei dem auf einer Seite eines aus einem halbleitenden Material gebildeten Chipkörpers (1) ein Schichtverband (2) zur Herstellung einer Lötverbindung vorgesehen ist, wobei der Schichtverband (2) aus mehreren übereinander folgenden, mittels Sputter-Verfahrens hergestellten Metallschichten (3, 4, 5, 6) gebildet ist, und wobei zwischen einer an einer Oberfläche des Schichtverbands (2) befindlichen Edelmetallschicht (6) und dem Chipkörper (1) eine lötbare Lötschicht (5) aus Ni oder einer Ni/V-Legierung vorgesehen ist,
**dadurch gekennzeichnet, dass**
die Lötschicht (5) zumindest eine durch eine Unterbrechung des Sputter-Verfahrens gebildete Grenzfläche (G1, G2) aufweist, wobei eine mittlere Kristallgröße der die Lötschicht (5) bildenden Kristalle in zumindest einer senkrecht von der Grenzfläche (G1, G2) weg weisenden Richtung zunächst zunimmt, wobei eine mittlere Kristallgröße der die Lötschicht (5) bildenden Kristalle in einer Richtung von einer an einer Grenze zur einer weiteren Metallschicht befindlichen Kontaktfläche (K1, K2) zur Grenzfläche (G1, G2) hin zunächst zunimmt, wobei bei der Herstellung der Lötschicht (5) das Sputter-Verfahren zur Herstellung der zumindest einen Grenzfläche (G1, G2), jeweils für 1 bis 60 Sekunden unterbrochen wird und wobei es während der Unterbrechung des Sputter-Verfahrens zu einer Abkühlung einer zuvor abgeschiedenen Schicht kommt, wobei die Abkühlung im Bereich von 30 bis 100°C liegt.

2. Chip nach Anspruch 1, wobei eine im Kontakt mit dem Chipkörper (1) befindliche Basisschicht (3) des Schichtverbands (2) aus Aluminium gebildet ist.

3. Chip nach einem der vorhergehenden Ansprüche, wobei eine zwischen der Lötschicht (5) und der Basisschicht (3) vorgesehene erste Zwischenschicht (4) aus Ti oder Cr oder einer Legierung aus Ti und W gebildet ist.

4. Chip nach einem der vorhergehenden Ansprüche, wobei eine zwischen der Edelmetallschicht (6) und der Lötschicht (5) vorgesehene zweite Zwischenschicht aus Ti gebildet ist.

5. Chip nach einem der vorhergehenden Ansprüche, wobei das halbleitende Material aus einem der folgenden Materialien gebildet ist: Si, SiC, SiGe, GaAs.

6. Chip nach einem der vorhergehenden Ansprüche, wobei eine Häufigkeit von in der Lötschicht (5) enthaltenen Poren (P) im Bereich der Grenzfläche (G1, G2) ein Maximum aufweist.

7. Chip nach einem der vorhergehenden Ansprüche, wobei eine Dicke der Lötschicht (5) 0,7 bis 1,2 µm, vorzugsweise 0,8 bis 1,0 µm, beträgt.

8. Chip-Substrat-Verbund, bei dem ein Chip nach einem der vorhergehenden Ansprüche mittels eines mit der Lötschicht (5) verbundenen Lots (7) mit einem Substrat (8) verbunden ist.

9. Chip-Substrat-Verbund nach Anspruch 8, wobei das Substrat (8) ein DCB-Substrat ist, und das Lot (7) mit einer auf dem DCB-Substrat vorgesehenen Kupferschicht (10) in Kontakt ist.

10. Chip-Substrat-Verbund nach Anspruch 8 oder 9, wobei das Lot (7) aus einer aus Sn und Ag gebildeten Legierung hergestellt ist.

11. Verfahren zur Herstellung eines Chips, bei dem auf einer Seite eines aus einem halbleitenden Material gebildeten Chipkörpers (1) ein Schichtverband (2) zur Herstellung einer Lötverbindung vorgesehen ist, wobei der Schichtverband (2) aus mehreren übereinander folgenden, mittels Sputter-Verfahrens hergestellten Metallschichten (3, 4, 5, 6) gebildet wird, und wobei zwischen einer an einer Oberfläche des Schichtverbands (2) befindlichen Edelmetallschicht (6) und dem Chipkörper (1) eine lötbare Lötschicht (5) aus Ni oder einer Ni/V-Legierung gebildet wird,
**dadurch gekennzeichnet, dass**
die Lötschicht (5) zumindest eine durch eine Unterbrechung des Sputter-Verfahrens gebildete Grenzfläche (G1, G2) aufweist, wobei eine mittlere Kristallgröße der die Lötschicht (5) bildenden Kristalle in zumindest einer senkrecht von der Grenzfläche (G1, G2) weg weisenden Richtung zunächst zunimmt, wobei eine mittlere Kristallgröße der die Lötschicht (5) bildenden Kristalle in einer Richtung von einer an einer Grenze zur einer weiteren Metallschicht befindlichen Kontaktfläche (K1, K2) zur Grenzfläche (G1, G2) hin zunächst zunimmt, wobei bei der Herstellung der Lötschicht (5) das Sputter-Verfahren zur Herstellung der zumindest einen Grenzfläche (G1, G2), jeweils für 1 bis 60 Sekunden unterbrochen wird und wobei es während der Unterbrechung des Sputter-Verfahrens zu einer Abkühlung einer zuvor abgeschiedenen Schicht kommt, wobei die Abkühlung im Bereich von 30 bis 100°C liegt.

12. Verfahren zur Herstellung eines Chips nach Anspruch 11, wobei eine im Kontakt mit dem Chipkörper (1) befindliche Basisschicht (3) des Schichtverbands (2) aus Aluminium gebildet ist.

13. Verfahren zur Herstellung eines Chips nach einem der Ansprüche 11 oder 12, wobei eine zwischen der Lötschicht (5) und der Basisschicht (3) vorgesehene erste Zwischenschicht (4) aus Ti oder Cr oder einer Legierung aus Ti und W gebildet ist.

14. Verfahren zur Herstellung eines Chips nach einem der Ansprüche 11 bis 13, wobei eine zwischen der Edelmetallschicht (6) und der Lötschicht (5) vorgesehene zweite Zwischenschicht aus Ti gebildet ist.

15. Verfahren zur Herstellung eines Chips nach einem der Ansprüche 11 bis 14, wobei das halbleitende Material aus einem der folgenden Materialien gebildet ist: Si, SiC, SiGe, GaAs.

16. Verfahren zur Herstellung eines Chips nach einem der Ansprüche 11 bis 15 wobei eine Häufigkeit von in der Lötschicht (5) enthaltenen Poren (P) im Bereich der Grenzfläche (G1, G2) ein Maximum aufweist.

17. Verfahren zur Herstellung eines Chips nach einem der Ansprüche 11 bis 16, wobei eine Dicke der Lötschicht (5) 0,7 bis 1,2 µm, vorzugsweise 0,8 bis 1,0 µm, beträgt.

## Claims

1. A chip, in which a layer assembly (2) is provided on one side of a chip body (1) formed from a semiconductor material in order to create a solder joint, wherein the layer assembly (2) is formed from a plurality of metal layers (3, 4, 5, 6) produced consecutively one on top of the other by means of a sputtering method, and wherein a solderable solder layer (5) formed from Ni or an Ni/V alloy is provided between a precious metal layer (6) on a surface of the layer assembly (2) and the chip body (1),
**characterized in that**
the solder layer (5) comprises at least one boundary surface (G1, G2) of Ni or an Ni/V alloy formed by an interruption in the sputtering process, wherein an average crystal size of the crystals forming the solder layer (5) initially increases in at least a direction receding perpendicularly from the boundary surface (G1, G2), wherein an average size of the crystals that form the solder layer (5) initially increases in a direction from a contact surface (K1, K2) on a boundary with an adjacent metal layer towards the boundary surface (G1, G2), wherein when creating the solder layer (5) the sputtering process for producing the at least one boundary surface (G1, G2) is interrupted in each case for 1 to 60 seconds, and wherein a layer deposited previously cools down during the interruption in the sputtering process, said cooling being in a temperature range from 30 to 100 °C.

2. The chip according to claim 1, wherein a base layer (3) of the layer assembly (2) that is in contact with the chip body (1) consists of aluminium.

3. The chip according to either of the preceding claims,
wherein a first intermediate layer (4) of Ti or Cr or an alloy of Ti and W is formed between the solder layer (5) and the base layer (3).

4. The chip according to any of the preceding claims,
wherein a second intermediate layer provided between the precious metal layer (6) and the solder layer (5) consists of Ti.

5. The chip according to any of the preceding claims,
wherein the semiconductive material is formed from one of the following materials: Si, SiC, SiGe, GaAs.

6. The chip according to any of the preceding claims,
wherein a frequency of the pores (P) contained in the solder layer (5) has a maximum in the region of the boundary surface (G1, G2).

7. The chip according to any of the preceding claims,
wherein a thickness of the solder layer (5) is 0.7 to 1.2 µm, preferably 0.8 to 1.0 µm.

8. A chip-substrate composite in which a chip according to any of the preceding claims is joined to a substrate (8) by means of a solder (7) that is bonded to solder layer (5).

9. The chip-substrate composite according to claim 8,
wherein the substrate (8) is a DCB substrate, and the solder (7) is in contact with a copper layer (10) provided on top of the DCB substrate.

10. The chip-substrate composite according to claim 8 or 9, wherein the solder (7) is produced from an alloy formed from Sn and Ag.

11. A method for producing a chip, in which a layer assembly (2) is provided on one side of a chip body (1) formed from a semiconductor material in order to create a solder joint, wherein the layer assembly (2) is formed from a plurality of metal layers (3, 4, 5, 6) produced consecutively one on top of the other by means of a sputtering method, and wherein a solderable solder layer (5) formed from Ni or an Ni/V alloy is provided between a precious metal layer (6) on a surface of the layer assembly (2) and the chip body (1),
**characterized in that**
the solder layer (5) comprises at least one boundary surface (G1, G2) of Ni or an Ni/V alloy formed by an interruption in the sputtering process, wherein an average crystal size of the crystals forming the solder layer (5) initially increases in at least a direction receding perpendicularly from the boundary surface (G1, G2), wherein an average size of the crystals that form the solder layer (5) initially increases in a direction from a contact surface (K1, K2) on a boundary with an adjacent metal layer towards the boundary surface (G1, G2), wherein when creating the solder layer (5) the sputtering process for producing the at least one boundary surface (G1, G2) is interrupted in each case for 1 to 60 seconds, and wherein a layer deposited previously cools down during the interruption in the sputtering process, said cooling being in a temperature range from 30 to 100 °C.

12. A method for producing a chip according to claim 11,
wherein a base layer (3) of the layer assembly (2) that is in contact with the chip body (1) is made from aluminium.

13. The method for producing a chip according to either of claims 11 or 12, wherein a first intermediate layer (4) provided between the solder layer (5) and the base layer (3) is made from Ti or Cr or an alloy of Ti and W.

14. The method for producing a chip according to any of claims 11 to 13, wherein a second intermediate layer provided between the precious metal layer (6) and the solder layer (5) consists of Ti.

15. The method for producing a chip according to any of claims 11 to 14, wherein the semiconductive material is formed from one of the following materials: Si, SiC, SiGe, GaAs.

16. The method for producing a chip according to any of claims 11 to 15, wherein a frequency of the pores (P) contained in the solder layer (5) has a maximum in the region of the boundary surface (G1, G2).

17. The method for producing a chip according to any of claims 11 to 16, wherein a thickness of the solder layer (5) is 0.7 to 1.2 µm, preferably 0.8 to 1.0 µm.

## Revendications

1. Puce, un ensemble de couches (2) étant prévu pour la réalisation d'une connexion par brasage sur une face d'un corps de puce (1) constitué d'un matériau semiconducteur, l'ensemble de couches (2) étant formé de plusieurs couches métalliques (3, 4, 5, 6) superposées, réalisées par pulvérisation cathodique, et une couche de brasage (5) soudable en Ni ou en alliage Ni/V est prévue entre une couche de métal noble (6) disposée à une surface de l'ensemble de couches (2) et le corps de puce (1),
**caractérisée en ce que** :
la couche de brasage (5) présente au moins une surface de délimitation (G1, G2) formée par interruption de la pulvérisation cathodique, une grosseur moyenne des cristaux formant la couche de brasage (5) augmentant d'abord dans au moins une direction perpendiculaire à la surface de délimitation (G1, G2) à mesure qu'on s'éloigne de celle-ci, une grosseur moyenne des cristaux formant la couche de brasage (5) augmentant d'abord dans une direction allant d'une surface de contact (K1, K2), limitrophe à une autre couche métallique, vers la surface de délimitation (G1, G2), la pulvérisation cathodique pour la production de l'au moins une surface de délimitation (G1, G2) étant interrompue de 1 à 60 secondes lors de la réalisation de la couche de brasage (5), et un refroidissement d'une couche antérieurement déposée ayant lieu en cours d'interruption de la pulvérisation cathodique, le refroidissement étant de l'ordre de 30 à 100°C.

2. Puce selon la revendication 1, dans laquelle une couche de base (3) de l'ensemble de couches (2) en contact avec le corps de puce (1) est en aluminium.

3. Puce selon l'une des revendications précédentes, dans laquelle une première couche intercalaire (4) prévue entre la couche de brasage (5) et la couche de base (3) est en Ti ou Cr ou en alliage de Ti et W.

4. Puce selon l'une des revendications précédentes, dans laquelle une deuxième couche intercalaire prévue entre la couche de métal noble (6) et la couche de brasage (5) est en Ti.

5. Puce selon l'une des revendications précédentes, dans laquelle le matériau semi-conducteur est un des matériaux suivants : Si, SiC, SiGe, GaAs.

6. Puce selon l'une des revendications précédentes, dans laquelle une fréquence des pores (P) contenus dans la couche de brasage (5) présente un maximum au niveau de la surface de délimitation (G1, G2).

7. Puce selon l'une des revendications précédentes, dans laquelle une épaisseur de la couche de brasage (5) est comprise entre 0,7 et 1,2 µm, préférentiellement entre 0,8 et 1,0 µm.

8. Assemblage puce-substrat, une puce selon l'une des revendications précédentes étant liée à un substrat (8) au moyen d'un métal d'apport (7) lié à la couche de brasage (5).

9. Assemblage puce-substrat selon la revendication 8, dans lequel le substrat (8) est un substrat DCB, et le métal d'apport (7) est en contact avec une couche de cuivre (10) prévue sur le substrat DCB.

10. Assemblage puce-substrat selon la revendication 8 ou 9, dans lequel le métal d'apport (7) est en alliage de Sn et Ag.

11. Procédé de fabrication d'une puce, un ensemble de couches (2) étant prévu pour la réalisation d'une connexion par brasage sur une face d'un corps de puce (1) constitué d'un matériau semi-conducteur, l'ensemble de couches (2) étant formé de plusieurs couches métalliques (3, 4, 5, 6) superposées, réalisées par pulvérisation cathodique, et une couche de brasage (5) soudable en Ni ou en alliage Ni/V étant prévue entre une couche de métal noble (6) disposée à une surface de l'ensemble de couches (2) et le corps de puce (1),
**caractérisé en ce que** :
la couche de brasage (5) présente au moins une surface de délimitation (G1, G2) formée par interruption de la pulvérisation cathodique, une grosseur moyenne des cristaux formant la couche de brasage (5) augmentant d'abord dans au moins une direction perpendiculaire à la surface de délimitation (G1, G2) à mesure qu'on s'éloigne de celle-ci, une grosseur moyenne des cristaux formant la couche de brasage (5) augmentant d'abord dans une direction allant d'une surface de contact (K1, K2), limitrophe à une autre couche métallique, vers la surface de délimitation (G1, G2), la pulvérisation cathodique pour la production de l'au moins une surface de délimitation (G1, G2) étant interrompue de 1 à 60 secondes lors de la réalisation de la couche de brasage (5), et un refroidissement d'une couche antérieurement déposée ayant lieu en cours d'interruption de la pulvérisation cathodique, le refroidissement étant de l'ordre de 30 à 100°C.

12. Procédé de fabrication d'une puce selon la revendication 11, dans lequel une couche de base (3) de l'ensemble de couches (2) en contact avec le corps de puce (1) est en aluminium.

13. Procédé de fabrication d'une puce selon l'une des revendications 11 et 12, dans lequel une première couche intercalaire (4) prévue entre la couche de brasage (5) et la couche de base (3) est en Ti ou Cr ou en alliage de Ti et W.

14. Procédé de fabrication d'une puce selon l'une des revendications 11 à 13, dans lequel une deuxième couche intercalaire prévue entre la couche de métal noble (6) et la couche de brasage (5) est en Ti.

15. Procédé de fabrication d'une puce selon l'une des revendications 11 à 14, dans lequel le matériau semiconducteur est un des matériaux suivants : Si, SiC, SiGe, GaAs.

16. Procédé de fabrication d'une puce selon l'une des revendications 11 à 15, dans lequel une fréquence des pores (P) contenus dans la couche de brasage (5) présente un maximum au niveau de la surface de délimitation (G1, G2).

17. Procédé de fabrication d'une puce selon l'une des revendications 11 à 16, dans lequel une épaisseur de la couche de brasage (5) est comprise entre 0,7 et 1,2 µm, préférentiellement entre 0,8 et 1,0 µm.
